# EUROPÄISCHE PATENTANMELDUNG

(11) **EP 0 610 728 A1**
(43) Veröffentlichungstag der Anmeldung: **17.08.1994**
(21) Anmeldenummer: 94101204.9
(22) Anmeldetag: 27.01.1994
(51) Int. Cl.: C23C 16/50, C23C 16/44, C23C 16/34

(54) **Verfahren zur mikrowellenunterstützten chemischen Abscheidung von Metall- und Metalloidschichten aus der Gasphase**

(30) Priorität: 09.02.1993 DE 4303749; 03.03.1993 DE 4306659
(71) Anmelder: SIEMENS AKTIENGESELLSCHAFT, D-80333 München (DE)
(72) Erfinder: Intemann, Andreas, Dipl.-Phys., D-85356 Freising (DE); Körner, Heinrich, Dr., Dipl.-Chem., D-83052 Bruckmühl (DE); Hieber, Konrad, Dr. Dipl.-Phys., D-85630 Neukeferloh (DE)

(57) **Zusammenfassung**

Ein mindestens Wasserstoff enthaltener Teil der Reaktionsgase wird räumlich getrennt von der Abscheidereaktion durch Mikrowellenenergie angeregt und anschließend einem Reaktor zugeleitet, in dem unter zusätzlicher separater Einführung von nichtangeregten Reaktionsgasen mit unzerstörten metalltragenden Gasmolekülen eine chemische Abscheidereaktion durchgeführt wird.

## Beschreibung

Die Erfindung betrifft ein Verfahren zur mikrowellenunterstützten chemischen Abscheidung von Metall- und Metalloidschichten aus der Gasphase bei der Herstellung integrierter Halbleiterschaltungen.

In der Mikroelektronik werden Metall- und Metalloidschichten für die vielfältigsten Anwendungszwecke benötigt. Diese sind z. B. als Leitbahn für die Verdrahtung einzelner Bauelemente im Schaltkreis oder als leitende Barriereschicht, um eine Interdiffusion zwischen zwei Leitern, die nicht in gegenseitigem Kontakt stehen dürfen, zu verhindern. Des weiteren finden solche Filme als Kontaktschicht oder Antireflexschichten Verwendung.

Mit zunehmender Miniaturisierung der Schaltkreise werden die Anforderungen an diese Schichten immer höher, die Forderung nach höchster Reinheit immer dringender. Die erzeugten Schichten müssen extrem zuverlässig sein, um auch noch in kleinsten Strukturen hohen Belastungen (d. h. Stromdichten) standhalten zu können. Des weiteren müssen auch unter diesen Bedingungen zuverlässige und niederohmige Kontaktzonen durch die Metallfilme erzeugt und gewährleistet werden. Ein zu hoher Gehalt an Fremdatomen in diesen Schichten führt unter extremen Anforderungen (kleine Strukturen, hohe Stromdichten) zur Degradation oder Zerstörung der Schicht selbst und deren Eigenschaften, aber auch benachbarter, anderweitig erzeugter Schichten. Insbesondere ist bekannt, daß eine hohe Chlorkonzentration in Titannitrid (Barriere für Aluminium) zu einer Korrosion einer darüberliegenden Aluminiumschicht fuhrt (Elektromigration).

Von diesen leitenden Schichten wird weiterhin eine hohe Konformität und eine gute Kantenbedeckung bei der Beschichtung gefordert. Dies ist auch unbedingt nötig, da dünne Bereiche, die sich in kleinen Strukturen ergeben können, schnell zu einer erhöhten Stromdichte führen und sich hier lokal starke Erwärmungseffekte einstellen würden, die schließlich einen Ausfall des Bauelements herbeiführen.

Weiterhin ist es außerdem wünschenswert, daß die erzeugte Schicht zur Planarisierung der Substratoberfläche beiträgt oder zumindest unterstützt. Von genereller Bedeutung ist die Forderung, daß die Beschichtung mit diesen leitenden Metall- oder Metallverbindungsschichten bei Substrattemperaturen unter 450°C mit der erforderlichen Qualität möglich ist. Dies ist notwendig, wenn die Schichten auch bei den neuen Technologien der Mehrlagenmetallisierung zum Einsatz kommen sollen. Denn sollte auf dem zu beschichtenden Substrat bereits eine bei niedriger Temperatur schmelzende Metallschicht, z. B. Aluminium, vorhanden sein, so muß die Beschichtungstemperatur auf jeden Fall niedrig gehalten werden. Eine Beschädigung oder Veränderung der vorher erzeugten Schichten muß auf jeden Fall ausgeschlossen sein.

Aufgrund der genannten vielfältigen Anforderungen sind die bekannten Verfahren zur Erzeugung solcher Metallverbindungsschichten wenig geeignet. Sputterverfahren beispielsweise beschichten nicht konform genug, während rein thermische CVD-Verfahren (Chemical Vapor Deposition) nur bei zu hohen Temperaturen fertigungstauglich sind.

ECR-CVD-Verfahren (Electron-Cyclotron-Resonance-CVD) andererseits fuhren zu einer Schichtabscheidung mit einer hohen Bodenbedeckung in kleinen Strukturen, die Beschichtung ist aber nicht konform, d. h. die senkrechten Wände bleiben nahezu unbeschichtet. Die Substrattemperatur muß trotz dieser Anregungsart nahezu genau so hoch gewählt werden wie bei rein thermischen Verfahren, um geeignete und ausreichende Schichtqualitäten zu erreichen.

So enthalt z. B. eine aus Titantetrachlorid (TiCl₄) und Ammoniak (NH₃) abgeschiedene Tintannitrid-Schicht (TiN) trotzdem einige at% Chlor bei 500°C Substrattemperatur. Weiterhin ist aus dem Artikel von T. Akahori et al., Int. Conf. on Solid State Devices, Yokohama, 1991, pp. 180 - 182, bekannt, daß zur Abscheidung derselben TiN-Schicht mit hochenergetischen (1 - 2.8 kW) Stickstoff, Wasserstoff und Argon ECR-Plasmen vergleichsweise hohe Substrattemperaturen von 540°C benötigt werden, um entsprechende Schichtqualitäten erreichen zu können.

In der nicht vorveröffentlichten deutschen Patentanmeldung Nr. P 41 32 560.5 (entspricht der US-Anmeldung, Ser. No. 07/954,974) wird ein Verfahren zur plasmaunterstutzten Abscheidung von Schichten aus der Gasphase (PECVD) mit externer Mikrowellenanregung vorgeschlagen, bei dem vorangeregter Stickstoff im Reaktor mit nichtangeregtem Tetrakis-(dimethylamino)-titan (TMT) zusammengeführt und anschließend eine Titannitridschicht in einem schwachen Hochfrequenzplasma abgeschieden wird. Bei den zur vorliegenden Erfindung führenden Untersuchungen hat sich jedoch herausgestellt, daß die erzeugte TiN-Schicht zwar eine ausreichende mechanische Stabilität aufgrund der Verdichtung ihres inneren Gefüges aufweist, daß jedoch aufgrund unterschiedlicher beteiligter Reaktionsmechanismen und wegen der unkontrollierten Zersetzung der metallorganischen Substanz im HF-Plasma eine undefinierte und angesichts der oben genannten Anforderungen unbrauchbare Schicht entsteht.

Der vorliegenden Erfindung liegt die Aufgabe zugrunde, ein den genannten Anforderungen genügendes Verfahren anzugeben.

Zur Lösung dieser Aufgabe ist erfindungsgemäß ein Verfahren der eingangs genannten Art vorgesehen, bei dem ein mindestens Wasserstoff enthaltener Teil der Reaktionsgase räumlich getrennt von der Abscheidereaktion durch Mikrowellenenergie angeregt und anschließend einem Reaktor zugeleitet wird, in dem unter zusätzlicher separater Einfuhrung von nichtangeregten Reaktionsgasen mit unzerstörten metalltragenden Gasmolekülen eine chemische Abscheidereaktion durchgeführt wird.

Vorteilhafterweise können gemäß einer Ausgestaltung der Erfindung nur Wasserstoffradikale, gegebenenfalls höchstens noch durch angeregte inerte Edelgase ergänzt, zur Anregung der Abscheidereaktion verwendet werden. Bei Verwendung einer nichtangeregten metallorganischen Titanverbindung wie TMT, in der Titan und Stickstoff direkt aneinander gebunden sind, können auch ohne angeregten Stickstoff oder Ammoniak hochwertige Titan- und Titannitridschichten abgeschieden werden.

Der Erfindung liegt die Entdeckung eines neuen Reaktionsmechanismus zugrunde. Der bekannte Mechanismus bei einer rein thermischen Reaktion beruht auf Substitution, wobei sich ein Ammoniakmolekül an das Titan-Atom im TMT-Molekül anlagert und sich die vier N (CH₃)₂ Liganden anschließend sukzessive unter Bildung flüchtiger Abgangsgruppen abspalten, wobei schließlich HN (CH₃)₂, N₂ und H₂ übrigbleiben.

Im Gegensatz dazu verwendet das erfindungsgemäße Verfahren keinerlei Substitutionsmechanismus:

I Ti [N (CH₃)₂]₄ + 4 H* ⇒ "Ti" + 4 HN (CH₃)₂

II "Ti" + 2 HN (CH₃)₂ ⇒ TiN + 2 C₂H₆ + 2 CH₄ + 1/2 N₂

III oder "Ti" + N* ⇒ TiN

Aus den ersten beiden Gleichungen ist ersichtlich, daß das Verfahren über die Bildung von intermediärem Titan "Ti" abläuft und nicht auf die Anwesenheit von angeregtem N₂ oder NH₃ angewiesen ist. Dieser Reaktionsverlauf wird durch die Entstehung der flüchtigen Kohlenwasserstoffe gemäß Gleichung II, die den Zerfall der N (CH₃)₂-Gruppen voraussetzen, bestätigt. Wird dennoch angeregter Stickstoff zugesetzt, so verläuft auch in diesem Fall die Raktion über das intermediär gebildete Titan gemäß Gleichung III. Unerwartet und überraschenderweise ergibt sich also ein völlig neuer physikalischchemischer Vorgang bei der Reaktion von metallhaltigen Molekülen mit Radikalen aus einer Mikrowellenquelle. Dieses neuartige Umsetzungsverhalten von angeregten Spezies mit anderen Molekülen auf beheizten Substraten ist somit deutlich von anderen, bisher bekannten Prozessen zu unterscheiden und bringt vielfältige Verbesserungen, nicht nur die Verringerung der Raktionstemperatur, mit sich.

Weitere Ausgestaltungen und Vorteile der Erfindung, die im folgenden anhand von Ausführungsbeispielen noch näher erläutert wird, sind Gegenstand von Unteransprüchen.

Durch das remote-Plasma Konzept ist es möglich, daß keine unerwünschte Fragmentierung anderer, aber zur Abscheidung notwendiger Komponenten stattfindet und deshalb die Radikale mit dem unzerstörten metalltragenden Molekül an der Substratoberfläche reagieren können. Eine Abscheidung höchstreiner Metall- oder Metalloidfilme ist damit möglich. Die Steuerung der gewünschten Zusammensetzung der Schichten ist durch geeignete Wahl der Gasmischung und des Gasverhältnisses in der Mikrowelle sowie anderer Abscheideparameter möglich.

Hierzu ist der Radikalgenerator so angeordnet, daß die angeregten Spezies direkt und mit möglichst wenigen Wandstößen in den Reaktionsraum gelangen und dort möglichst konzentriert zur Umsetzung zur Verfügung stehen. Weiterhin muß dabei beachtet werden, daß die Zeitspanne zwischen der Erzeugung der Radikale im Plasma und deren Umsetzung im Reaktionsraum kurz ist, damit noch ein maßgeblicher Anteil an nicht rekombinierten Teilchen vorhanden ist. Ein großer Durchmesser des Zuleitungsrohres und gerade Wege sind deshalb vorteilhaft. Andererseits muß aber auch eine ausreichende Vermischung mit den anderen zugeführten, nicht angeregten Komponenten gewährleistet sein, um eine homogene Schichtverteilung zu erreichen. Dies wird durch eine separate, beheitzte Zuleitung für die metallorganische Substanz sowie durch strömungstechnische Maßnahmen gewährleistet.

Im Reaktor selbst findet die chemische Reaktion zwischen den angeregten Spezies oder Radikalen und den separat über die eigene Versorgungsleitung zugeführten, nicht angeregten Molekülen auf dem beheizten Substrat statt. Hierbei bildet sich die gewünschte Schicht in ensprechender Reinheit, abhängig von den zugeführten, unangeregten Gasen und Molekülen, von den in dem Mikrowellengenerator angeregten Gasen oder Gasgemischen sowie weiteren Prozeßparametern wie Druck, Temperatur, Gasfluß.

Als Beispiele hierzu seien zwei Reaktionsprozesse zur Abscheidung von Titannitrid (TiN) genannt:
a) MOCVD von TiN aus Tetrakis-(dimethylamino)-titan (TMT) und N₂/H₂-Anregung im remote-Mikrowellenplasma:
   Bei diesem Prozeß findet eine Umsetzung mit den am Substrat angebotenen Stickstoff- und Wasserstoffradikalen (N* und H*) statt. Hier ersetzen die Radikale z. B. nicht den Ammoniak in dem bereits bekannten thermischen Prozeß. Man findet im Gegensatz hier einen anderen Umsetzungsmechanismus als mit NH₃; dies ist u. a. an einer unterschiedlichen Zusammensetzung bei sonst gleichen Bedingungen, aber auch an einer wesentlich besseren Kantenbedeckung erkennbar.
b) Abscheidung von TiN aus Titantetrachlorid (TiCl₄) und N₂/H₂-Anregung im Mikrowellenplasma:
   Durch die Umsetzung von TiCl₄ mit Wasserstoffradikalen und, gegebenenfalls, einem optimierten Anteil an Stickstoffradikalen lassen sich Titan-, titanreiche Titannitridschichten sowie perfekte, fremdatomfreie Titannitridschichten abscheiden. Des weiteren ist eine Steuerung der Zusammensetzung durch Zugabe weiterer Gase möglich (z. B. Silan (SiH₄) führt ggf. zu Titan-Silizium-Verbindungsschichten). Auch bei diesem Prozeß ist ein neuer, anderer Umsetzungsmechanismus vorherrschend. Dieser hat wiederum entscheidende Vorteile gegenüber den bekannten Verfahren (thermisch mit Ammoniak oder mit N₂/H₂ im HF-Kammerplasma):
   * Durch den Einsatz eines Mikrowellen-remote-Plasmas kann bei niedrigerer Substrattemperatur bei entsprechenden Schichteigenschaften abgeschieden werden. Dies hat einen größeren Applikationsbereich des Prozesses zur Folge, aber auch die entstehenden Halogene (Chlor in diesem Fall) zeigen kein so starkes Ätzverhalten gegenüber dem Substrat (encroachment).
   * Außerdem ist beim Verzicht auf NH₃ keine Salzbildung (Ammoniumchlorid) möglich, die Partikelgefahr dadurch ausgeschlossen. Eine Adduktbildung, wie sie bei der Verwendung von TiCl₄ und NH₃ möglich ist, kann bei obiger Prozeßfuhrung völlig ausgeschlossen werden.

Insgesamt erreicht man bei den Prozessen mit der Mikrowellenanregung trotz deutlich niedrigerer Abscheidetemperaturen als bei bekannten CVD-Verfahrren eine hohe Reinheit der Filme, niedrigere Fremdatomgehalte (z. B. Cl-Kontamination) und damit verbunden niedrige spezifische Widerstände.

Überraschenderweise bedarf es zur Erzeugung von TiN aus stickstoffhaltigen metallorganischen Titanverbindungen (wie z. B. TMT) nicht der Anregung von Stickstoff in der Mikrowelle. Unter bestimmten Bedingungen führt alleine die Anregung von Wasserstoff alleine oder von Wasserstoff-/Edelgas-Gemischen zu Titannitridschichten von hoher Qualität und hoher Reinheit mit den zuvor genannten Vorteilen. Als Beschichtungsparameter hierzu seien folgende Bereiche genannt:

| | |
|---|---|
| Prozeßdruck: | 0,10 - 15 hPa |
| Substrattemperatur: | 250°C bis 500°C |
| Mikrowellenleistung: | 50 - 850 Watt |
| Stickstoff-, Argonfluß: | 5 - 100 sccm |
| TMT-Fluß: | 0,1 - 10 sccm |
| Wasserstofffluß: | 10 - 1000 sccm |

Unter anderen Bedingungen sind sogar titanreiche Schichten oder sogar reine Titanschichten möglich. Auch hierzu einige typische Parameterbereiche:

| | |
|---|---|
| Prozeßdruck: | 0,05 - 20 hPa |
| Substrattemperatur: | 300°C - 550°C |
| Mikrowellenleistung: | 100 - 850 Watt |
| Wasserstofffluß: | 50 - 500 sccm |
| Argonfluß: | 10 - 100 sccm |
| Titantetrachloridfluß: | 0,1 - 20 sccm |

Die Umsetzungen selbst lassen sich prinzipiell mit den bekannten Reaktionsgleichungen beschreiben, wobei diese oberflächenkontrolliert auf dem Substrat ablauft. Hierzu seien noch einige Beispiele angeführt:
Ti(NR₂)₄ + 4 H* ⇒ Ti + 4 HNR₂;
TiCl₄ + 4 H* ⇒ Ti + 4 HCl;
Ti(NR₂)₄ + 4 H* + N* ⇒ TiN + 4 HNR₂;
WF₆ + 6 H* ⇒ W + 6 HF;
Ti[N(CH₃)₂]₄ + 6 H* ⇒ TiN + 3 HN(CH₃)₂ + C₂H_{6;}
TiCl⁴ + N* + 4 H* ⇒ TiN + 4 HCl;
TiCl₄ + 4 H* + x SiH₄ ⇒ TiSiₓ + 4 HCl + 2 x H₂.

Durch die Einleitung von Wasserstoffradikalen und/oder Gemischen aus Stickstoff- und Wasserstoffradikalen, verbunden mit einer Edelgaszumischung je nach Anwendung, lassen sich aber auch die nach obigen Verfahren erzeugten Schichten nachbehandeln und in ihrer Struktur verändern. So ist eine Verdichtung bzw. Homogenisierung möglich, verbunden mit einer Struktur- und/oder Eigenschaftsänderung der abgeschiedenen Kristallite. Diese, durch die Nachbehandlung erzeugten Veränderungen können beispielsweise am spezifischen Widerstand oder an der Härte der Schicht abgelesen und beurteilt werden.

Zusammenfassend lassen sich die Vorteile des erfindungsgemäßen Verfahrens folgendermaßen beschreiben:
Die Qualität der erzeugten Schichten entspricht bezüglich Stöchiometrie, Reinheit und Kantenbedeckung jenen aus mit rein thermischen Prozessen oder Plasmaprozessen abgeschiedenen oder ist deutlich verbessert, obwohl die Umsetzung der Substanzen nach einem neuen Mechanismus mit Radikalen stattfindet.

Mit diesen RP-CVD Prozessen sind neuartige Schichten, Schichtsysteme und bei Verbindungsschichten spezielle Stöchiometrien herstellbar, wobei diese durch Variation der Prozeßgasanteile veränderbar sind.

Schichtsysteme unterschiedlicher Zusammensetzung können durch Veränderung der Prozeßgasanteile im Radikalgenerator während des Aufwachsens (in-situ) erzeugt werden, wobei die Stöchiometrie fließend von der kontinuierlichen Variation dieser Gasanteile oder der eingekoppelten Mikrowellenleistung abhängt.

Die Abscheidetemperatur der RP-CVD Prozesse liegt deutlich unter (bis zu 300°C und mehr) jenen der rein thermischen Prozesse oder Plasmaprozesse.

Anstelle von Ammoniak (NH₃) können geeignete Mischungen von in der Mikrowelle angeregte Gase verwendet werden (z. B. N₂, H₂ mit Ar, He, Kr), wobei der Molanteil eines oder mehrerer Komponenten hiervon (außer H₂) auch Null sein kann.

Zur Durchmischung der Gase, speziell für die von der Mikrowelle angeregten, muß kein Gasverteilungssystem, wie z. B. ein "showerhead", verwendet werden, sondern sie kann strömungstechnisch auf einfache Weise gelöst werden.

Die abgeschiedenen Schichten können durch die Einleitung von geeigneten Radikalen oder von nicht angeregten Gasen/Molekülen nach der Deposition derart verändert werden, daß eine Verdichtung, Homogenisierung und Stabilisierung der Schichteigenschaften erreicht wird.

## Patentansprüche

1. Verfahren zur mikrowellenunterstützten chemischen Abscheidung von Metall- und Metalloidschichten aus der Gasphase bei der Herstellung integrierter Halbleiterschaltungen, bei dem ein mindestens Wasserstoff enthaltener Teil der Reaktionsgase räumlich getrennt von der Abscheidereaktion durch Mikrowellenenergie angeregt und anschließend einem Reaktor zugeleitet wird, in dem unter zusätzlicher separater Einfuhrung von nichtangeregten Reaktionsgasen mit unzerstörten metalltragenden Gasmolekülen eine chemische Abscheidereaktion durchgeführt wird.

2. Verfahren nach Anspruch 1, bei dem neben angeregten Edelgasatomen nur Wasserstoffradikale verwendet werden.

3. Verfahren nach Anspruch 1, bei dem durch Veränderung der Anteile der angeregten Reaktionsgase Schichten mit einstellbarer Stöchiometrie abgeschieden werden.

4. Verfahren nach Anspruch 3, bei dem die Änderung der angeregten Reaktionsgasanteile während des Aufwachsens der Schicht erfolgt, wobei deren Stöchiometrie fließend von der kontinuierlichen Variation dieser Reaktionsgasanteile und der Variation der eingekoppelten Mikrowellenleistung abhängt.

5. Verfahren nach Anspruch 1, 3 oder 4, bei dem als nichtangeregtes metalltragendes Reaktionsgas eine Titanverbindung verwendet wird und durch Optimierung der Anteile eines angeregten Gemisches von Wasserstoff/Stickstoff-Radikalen eine titanreiche Titannitridschicht abgeschieden wird.

6. Verfahren nach Anspruch 1, 3 oder 4, bei dem als nichtangeregtes metalltragendes Reaktionsgas eine Titanverbindung verwendet wird und durch Optimierung der Anteile eines angeregten Gemisches von Wasserstoff/Stickstoff-Radikalen eine fremdatomfreie Titannitridschicht abgeschieden wird.

7. Verfahren nach einem der Ansprüche 1 bis 6, bei dem eine Metallhalogenverbindung, insbesondere TiCl₄ oder WF₆, als nichtangeregtes Reaktionsgas verwendet wird.

8. Verfahren nach einem der Ansprüche 1 bis 6, bei dem eine nichtangeregte metallorganische Titanverbindung, insbesondere Tetrakis-(dimethylamino)-titan, Ti[N(CH₃)₂]₄, verwendet wird, in der Titan und Stickstoff direkt aneinander gebunden sind.

9. Verfahren nach Anspruch 2 und 8, bei dem ohne Anregung von Stickstoff eine insbesondere titanreiche Titannitridschicht hoher Reinheit abgeschieden wird.

10. Verfahren nach Anspruch 2 und 7 oder 2 und 8, bei dem ohne Anregung von Stickstoff eine Metall-, insbesondere eine Titanschicht abgeschieden wird.

11. Verfahren nach Anspruch 1, 3 oder 4, bei dem durch Verwendung eines nichtangeregten Gemisches einer Titanverbindung, insbesondere TiCl₄, mit einer Siliziumverbindung, insbesondere Silan (SiH₄), eine Titansilizidschicht abgeschieden wird.

12. Verfahren nach einem der Ansprüche 1 bis 11, bei dem dem anzuregenden Teil der Reaktionsgase Edelgase, insbesondere Helium, Argon oder Krypton, beigemischt werden.
